# FASCICULE DE BREVET EUROPEEN

(11) **EP 0 484 257 B1**
(45) Date de publication et mention de la délivrance du brevet: **27.12.1995**
(21) Numéro de dépôt: 91420384.9
(22) Date de dépôt: 25.10.1991
(51) Int. Cl.: H01L 23/64, H01L 23/495

(54) **Circuit intégré à boîtier moulé comprenant un dispositif de réduction de l'impédance dynamique**
Gegossenes Gehäuse für eine integrierte Schaltung mit einer Vorrichtung zur Reduzierung der dynamischen Impedanz
Molded package for integrated circuit comprising a device for reducing the dynamic impedance

(30) Priorité: 29.10.1990 FR 9013741
(43) Date de publication de la demande: 06.05.1992
(73) Titulaire: SGS-THOMSON MICROELECTRONICS S.A., 94250 Gentilly (FR)
(72) Inventeur: Mermet-Guyennet, Michel, F-38000 Grenoble (FR)
(74) Mandataire: de Beaumont, Michel

(56) Documents cités:
- EP-A- 0 324 244
- SIXTH IEEE/CHMT INTERNATIONAL ELECTRONIC MANUFACTURING TECHNOLOGY SYMPOSIUM, PROCEEDINGS OF THE 1989 JAPAN IEMT SYMPOSIUM 26 Avril 1989, NARA, JP pages 221 - 229; D. MALLIK ET AL.: 'Multi-layer molded plastic package'
- PATENT ABSTRACTS OF JAPAN vol. 12, no. 328 (E-654)6 September 1988 & JP-A-63 092 047
- PATENT ABSTRACTS OF JAPAN vol. 12, no. 369 (E-665)4 October 1989 & JP-A-63 122 159

## Description

La présente invention concerne le domaine des circuits intégrés à boîtier moulé et notamment des circuits intégrés à boîtier moulé comprenant un dispositif de réduction de l'impédance dynamique des lignes d'alimentation.

Certains circuits intégrés nécessitent lors de leur fonctionnement de fortes pointes de courant. Il convient alors que les lignes d'alimentation présentent de faibles impédances dynamiques, c'est-à-dire que ces lignes aient chacune une faible résistance et une faible inductance et présentent une capacité de découplage reliée à une autre ligne d'alimentation.

Selon des techniques classiques de connexion, une solution pour diminuer les résistances et les inductances des liaisons consiste à multiplier le nombre de liaisons affectées aux tensions d'alimentation. Ainsi, les résistances et les inductances parasites sont mises en parallèle et leurs valeurs sont divisées pratiquement par le nombre de liaisons en parallèle. Mais si on veut diminuer suffisamment ces résistances et inductances parasites il faut augmenter considérablement le nombre de liaisons affectées aux alimentations, ce qui est incompatible avec des circuits intégrés nécessitant un grand nombre d'entrées/sorties.

Dans toute la suite de la description on désignera par réseau de connexion le plan des broches de connexion.

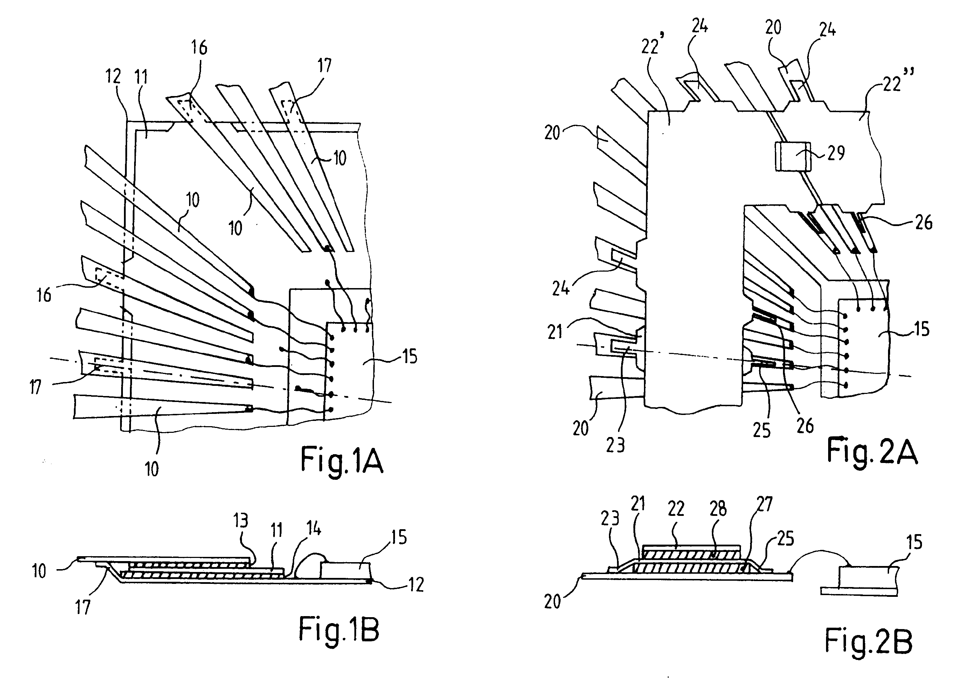

Les figures 1A et 1B représentent respectivement en vue de dessus et en section une grille de connexion multicouche adaptée à la technique à grille de connexion et liaison par fils et décrite dans Proceedings of the Sixth IEEE/CHMT International Electronic Manufacturing Technology Symposium, avril 1989, Nara, JP, pages 221 à 229, "Multi-Layer Molded Plastic Package". Cette grille de connexion comporte plusieurs couches constituées par une couche de broches ou réseau de connexion 10, un premier plan métallique 11 et un deuxième plan métallique 12, séparées les unes des autres par des films isolants 13 et 14 collés. Le plan 12 supporte une puce 15. Le plan 11 est annulaire pour laisser de la place autour de la puce 15 pour relier celle-ci au plan 12. Des pattes 16 sur la périphérie du plan 11 sont soudées sur des broches reliées à une première borne d'alimentation. De même, des pattes 17 sur la périphérie du plan 12 sont soudées à d'autres broches reliées à une deuxième borne d'alimentation. Les plots d'alimentation de la puce 15 normalement destinés à être reliés aux broches d'alimentation, sont reliés par des fils aux plans correspondants et les autres plots sont reliés par des fils aux extrémités proximales des broches restantes.

Ainsi, les liaisons d'alimentation passent par des plans au lieu de passer sur une grande longueur par des broches fines. Ceci diminue considérablement les résistances et les inductances parasites. De plus, les plans 11 et 12 forment une capacité de découplage entre les lignes d'alimentation.

Toutefois, par rapport à une réalisation comprenant seulement une couche correspondant au réseau de connexion 10, oette disposition nécessite le raccourcissement des extrémités des broches pour permettre la liaison des plots d'alimentation de la puce aux plans. Ceci entraîne la nécessité de fils plus longs entre les autres plots de la puce et les extrémités des broches. En pratique, on est limité à trois couches car, sinon, les fils de liaison entre la puce et les extrémités des broches seraient trop longs pour assurer une bonne fiabilité et, notamment, introduiraient des résistances et des inductances supplémentaires, ce qu'on veut justement éviter.

Un autre inconvénient de cette disposition est que les fils sont particulièrement difficiles à souder sur les extrémités proximales des broches de connexion car le film isolant 13 qui maintient ces dernières se ramollit sous l'effet de la chaleur du soudage.

De plus, ces grilles de connexion multicouche sont coûteuses car il faut réaliser les plans métalliques 11 et 12 par poinçonnage avec un outillage spécifique, et leur mise en oeuvre est délicate et nécessite une adaptation des procédés de manipulation et de soudure de grilles classiques étant donné que les fils de liaison sont de longueurs différentes.

Un objet de la présente invention est de prévoir un dispositif de réduction de l'impédance dynamique des lignes d'alimentation de réalisation simple, peu coûteuse et pouvant être utilisé avec des réseaux de connexion classiques sans modifier leur mode de connexion à la puce.

Un autre objet de la présente invention est de prévoir ce dispositif dans des circuits intégrés obtenus selon la technique TAB.

Ces objets ainsi que d'autres de la présente invention sont obtenus par un dispositif de réduction de l'impédance dynamique pour circuit intégré à boîtier moulé selon la revendication 1 comprenant une puce et plusieurs plans métalliques annulaires séparés les uns des autres par un film isolant, chacun de ces plans comportant sur sa limite extérieure des pattes reliées à l'extérieur du boîtier et sur sa limite intérieure des pattes reliées à des plots de la puce.

Selon un mode de réalisation de la présente invention, les pattes sont reliées à l'extérieur et aux plots de la puce par l'intermédiaire de broches d'un réseau de connexion classique.

Selon un mode de réalisation de la présente invention, les pattes sont soudées sur les broches.

Selon un mode de réalisation de la présente invention, les plans annulaires et leurs pattes sont obtenus par gravure d'un film métallique fixé sur une bande en matière plastique qui constitue le film isolant.

Selon un mode de réalisation de la présente invention, le réseau de connexion est aussi obtenu par gravure.

Selon un mode de réalisation de la présente invention, les broches du réseau sont reliées à des broches raccourcies d'une grille de connexion classique.

Selon un mode de réalisation de la présente invention, le plan annulaire de la dernière couche est en plusieurs parties.

Selon un mode de réalisation de la présente invention, le plan annulaire de la dernière couche comporte une capacité reliée entre des parties adjacentes.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1A et 1B, illustrant l'état de la technique, ont été précédemment décrites ;
les figures 2A et 2B représentent respectivement une vue de dessus et une section d'un mode de réalisation de la présente invention;
la figure 3 représente une section d'un autre mode de réalisation de la présente invention ; et
la figure 4 représente une vue de dessus d'encore un autre mode de réalisation de la présente invention.

Dans ces figures qui ne sont pas représentées à l'échelle réelle, des mêmes références désignent des mêmes éléments.

Les figures 2A et 2B illustrent un réseau de connexion 20 interne à un boîtier moulé de circuit intégré et appartenant à une grille de connexion classique. Selon la présente invention, deux plans annulaires métalliques 21 et 22 sont disposés sur les broches du réseau 20. Les limites extérieures des plans annulaires sont inscrites dans le boîtier et les limites intérieures laissent exposées les extrémités proximales des broches. Chaque plan annulaire est relié à un certain nombre de broches du réseau 20, par exemple affectées à une tension d'alimentation, par des pattes 23 et 24 de la limite extérieure de chaque plan et par des pattes 25 et 26 de leurs limites intérieures. On obtient ainsi un pontage des broches par un plan, ce qui revient à mettre les broches et le plan en parallèle et entraîne une diminution supplémentaire par rapport aux dispositifs classiques des résistances et inductances parasites.

Les plans annulaires 21 et 22 sont obtenus par gravure d'un film métallique fixé sur un film en matière plastique, comme c'est fait pour la technique de connexion dite TAB (de l'anglais "Tape Automated Bonding" ou Liaison Automatisée sur Bande). Cette technique permet une obtention aisée de plans annulaires de forme complexe. En outre, la bande en matière plastique constitue directement un film isolant (27 et 28) entre deux couches de plans annulaires.

Cette technique permet, selon un autre mode de réalisation de la présente invention et comme le montre la figure 2A, de réaliser au niveau du plan annulaire supérieur une division en plusieurs parties, ici deux 22′ et 22˝, reliées respectivement à des broches de potentiels différents. Ceci permet, dans les limites du boîtier moulé ultérieurement, de braser des capacités 29 en technologie CMS (Composants Montés en Surface) entre les deux parties 22′ et 22˝ du plan. On peut ainsi augmenter considérablement les capacités de découplage. Le réseau de connexion 20 représenté ici est celui d'une grille de connexion classique. Les extrémités des broches sont reliées à une puce 15 par des fils de même longueur.

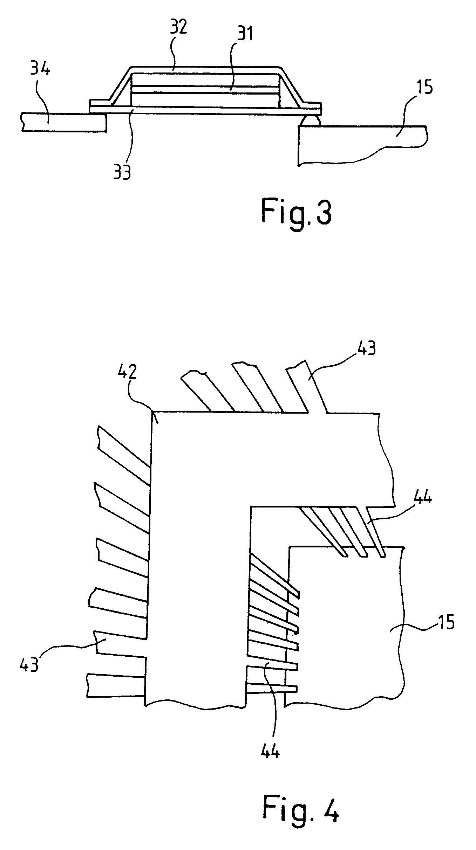

Selon un autre mode de réalisation de la présente invention, représenté dans une partie de la figure 3, des plans annulaires 31 et 32, de forme similaire à celle des plans 21 et 22 des figures 2A et 2B, sont disposés de la même manière que ci-dessus mais sur un réseau de connexion 33 réalisé et relié à une puce 15 selon la technique TAB.

On remarquera qu'il n'est pas nécessaire de modifier les réseaux de connexion classiques pour implémenter la présente invention et qu'il est possible de prévoir, dans les limites du boîtier moulé ultérieurement, autant de couches de plans métalliques que désiré.

La figure 3 illustre en outre un autre mode de réalisation de la présente invention. Les extrémités distales des broches du réseau 33 sont soudées aux extrémités proximales de connexions raccourcies 34 d'une grille de connexion classique.

La figure 4 représente un autre mode de réalisation de la présente invention. Dans un réseau de connexion réalisé pour la technique TAB, les broches destinées à être reliées à un plan annulaire 42 sont supprimées et ce sont les pattes 43 de la limite extérieure du plan et les pattes 44 de la limite intérieure, qui, en les prévoyant aux dimensions des broches supprimées, remplacent ces dernières.

Pour illustrer simplement la présente invention on n'a représenté dans les figures qu'une ou deux couches de plans annulaires. Il est facile, pour l'homme du métier employant les techniques de la présente invention, de prévoir autant de couches supplémentaires que nécessaire, dans les limites du boîtier obtenu ultérieurement, pour améliorer davantage les caractéristiques.

## Revendications

1. Dispositif de réduction de l'impédance dynamique pour circuit intégré à boitier moulé comprenant une puce (15) reliée à un réseau de connexion (20) et plusieurs plans métalliques annulaires (21, 22) arrangés l'un au-dessus de l'autre autour de la puce et séparés les uns des autres et du réseau de connexion par un film isolant (27, 28), chacun de ces plans comportant sur sa limite extérieure des pattes extérieures (23, 24), caractérisé en ce que chacun des plans comporte sur sa limite intérieure des pattes intérieures (25, 26) et chaque paire de pattes intérieure et extérieure remplace au moins partiellement une broche correspondante du réseau de connexion ou est reliée à celle-ci.

2. Dispositif de réduction de l'impédance dynamique selon la revendication 1, caractérisé en ce que le réseau de connexion est une grille de connexion classique.

3. Dispositif de réduction de l'impédance dynamique selon la revendication 1, caractérisé en ce que les plans annulaires (21, 22) et leurs pattes (23-26) sont gravés sur un film métallique fixé sur une bande en matière plastique qui constitue le film isolant (27, 28).

4. Dispositif de réduction de l'impédance dynamique selon la revendication 3, caractérisé en ce que le réseau de connexion (33) est aussi gravé.

5. Dispositif de réduction de l'impédance dynamique selon la revendication 4, caractérisé en ce que les broches du réseau (33) relient les broches (34) d'une grille de connexion classique aux plots de la puce.

6. Dispositif de réduction de l'impédance dynamique selon la revendication 1, caractérisé en ce que le plan annulaire (22) de la dernière couche est en plusieurs parties (22′, 22˝).

7. Dispositif de réduction de l'impédance dynamique selon la revendication 6, caractérisé en ce que le plan annulaire de la dernière couche comporte une capacité (29) reliée entre des parties adjacentes (22′, 22˝).

## Patentansprüche

1. Einrichtung zum Vermindern der dynamischen Impendanz in einer integrierten Schaltung mit einem gegossenen Gehäuse, mit einem Chip (15), der an ein Verbindungsnetzwerk (20) und mehrere metallische ringförmige Ebenen (21, 22) angeschlossen ist, welche um den Chip herum übereinander angeordnet sind und voneinander und von dem Verbindungsnetzwerk durch einen Isolierfilm (27, 28) getrennt sind, wobei jede dieser Ebenen an ihrer Außengrenze äußere Beine (23, 24) aufweist, dadurch **gekennzeichnet,** daß jede Ebene an ihrer inneren Grenze innere Beine (25, 26) aufweist und jedes Beinpaar aus inneren und äußeren Beinen zumindest teilweise einen entsprechenden Anschluß des Verbindungsnetzwerkes ersetzt oder mit diesem verbunden ist.

2. Einrichtung zum Vermindern der dynamischen Impedanz nach Anspruch 1, dadurch **gekennzeichnet,** daß das Verbindungsnetzwerk ein herkömmliches Anschlußgitter ist.

3. Einrichtung zum Vermindern der dynamischen Impedanz nach Anspruch 1, dadurch **gekennzeichnet,** daß die ringförmigen Ebenen (21, 22) und ihre Beine (23 bis 26) auf einem metallischen Film geätzt sind, der an einem Kunststoffband befestigt ist, welches den Isolierfilm (27, 28) bildet.

4. Einrichtung zum Vermindern der dynamischen Impedanz nach Anspruch 3, dadurch **gekennzeichnet,** daß auch das Verbindungsnetzwerk (33) geätzt ist.

5. Einrichtung zum Vermindern der dynamischen Impedanz nach Anspruch 4, dadurch **gekennzeichnet,** daß die Anschlüsse des Netzes (33) die Anschlüsse (34) eines klassischen Anschlußrahmens mit den Kontaktfeldern des Chips verbinden.

6. Einrichtung zum Vermindern der dynamischen Impedanz nach Anspruch 1, dadurch **gekennzeichnet,** daß die ringförmige Fläche (22) der letzten Schicht aus mehreren Abschnitten (22′, 22˝) besteht.

7. Einrichtung zum Vermindern der dynamischen Impedanz nach Anspruch 6, dadurch **gekennzeichnet,** daß die ringförmige Schicht der letzten Schicht eine Kapazität (29) trägt, die zwischen benachbarten Abschnitten (22′, 22˝) angeschlossen ist.

## Claims

1. A device for reducing dynamic impedances in a molded case integrated circuit comprising a chip (15) connected to a connection network (20) and a plurality of superposed annular metal planes (21, 22) around the chip and separated from each other and from the connection network by an insulating film (27, 28), each of said planes comprising, on its external border, external legs (23, 24), characterized in that each plan comprises on its internal border, internal legs (25, 26) and each pair of internal and external legs replaces, at least partially, a corresponding load of the connection network or is connected thereto.

2. A device for reducing dynamic impedances according to claim 1, characterized in that the connection network is a conventional lead frame.

3. A device for reducing dynamic impedances according to claim 1, characterized in that the annular planes (21, 22) and their legs (23-26) are etched on a metal film fixed on a plastic tape which constitutes the insulating film (27, 28).

4. A device for reducing dynamic impedances according to claim 3, characterized in that the connection network (33) is also etched.

5. A device for reducing dynamic impedances according to claim 4, characterized in that the leads of said network (33) connect the leads (34) of a conventional lead frame to the pads of the chip.

6. A device for reducing dynamic impedances according to claim 1, characterized in that the annular plane (22) of the last layer is comprised of several portions (22′, 22˝).

7. A device for reducing dynamic impedances according to claim 6, characterized in that the annular plane of the last layer comprises a capacitor (29) connected between adjacent portions (22′, 22˝).
